# EUROPEAN PATENT SPECIFICATION

(11) **EP 1 365 048 B1**
(45) Date of publication and mention of the grant of the patent: **09.05.2012**
(21) Application number: 02712433.8
(22) Date of filing: 18.02.2002
(51) Int. Cl.: C30B 29/06, C30B 15/20

(54) **METHOD FOR FABRICATING SILICON SINGLE CRYSTAL**
HERSTELLUNGSVERFAHREN FÜR SILIZIUM-EINKRISTALLE
PROCEDE DE FABRICATION D'UN MONOCRISTAL DE SILICIUM

(30) Priority: 16.02.2001 JP 2001039556
(43) Date of publication of application: 26.11.2003
(73) Proprietor: SUMCO CORPORATION, Minato-ku, Tokyo (JP); NEC Corporation, Minato-ku Tokyo 108-8001 (JP)
(72) Inventor: KANDA, T, c/o Sumitomo Mitsubishi Silicon Corp., Tokyo 105-8634 (JP); KURAGAKI, S, c/o Sumitomo Mitsubishi Silicon Corp., Tokyo 105-8634 (JP); WATANABE, M, c/o NEC Corporation, Tokyo 108-8001 (JP); EGUCHI, M, c/o NEC Corporation, Tokyo 108-8001 (JP)
(74) Representative: Uchida, Kenji
(86) International application number: PCT/JP2002/001388
(87) International publication number: WO 2002/064866

(56) References cited:
- EP-A1- 1 035 234
- DE-A1- 19 911 755
- JP-A- 2000 063 195
- US-A- 6 066 306
- WATANABE M; EGUCHI M; HIBIYA T: "Control and homogenization of oxygen distribution in Si crystals by the novel technique: electromagnetic Czochralski method (EMCZ)" PROCEEDINGS OF THE SPIE : MATERIALS RESEARCH IN LOW GRAVITY II 19-21 JULY 1999, vol. 3792, 1999, - 1999 pages 31-38, XP002506787 DENVER, CO, USA
- WATANABE M; EGUCHI M; HIBIYA T: "Silicon crystal growth by the electromagnetic Czochralski (EMCZ) method" JAPANESE JOURNAL OF APPLIED PHYSICS, PART 2 (LETTERS), vol. 38, no. 1A-B, 15 January 1999 (1999-01-15), pages L10-L13, XP002506788

## Description

### Technical Field

This invention relates to a method of producing silicon single crystals excellent in device characteristics such as gate oxide integrity and the like by the Czochralski method (hereinafter referred to as "CZ method") and, more particularly, to a method capable of producing silicon single crystals consisting of a dislocation cluster-free crystal region with high productivity without allowing formation of crystal originated particles (COPs) of not less than 0.1 µm in size.

### Background Art

Silicon wafers to be used in the production of semiconductor devices are being produced mainly from silicon single crystals grown by the CZ method. The CZ method comprises immersing a seed crystal in a silicon melt molten in a quartz crucible and pulling up the seed crystal while rotating the quartz crucible and seed crystal to thereby grow a cylindrical silicon single crystal on the lower end of the seed crystal.

In a silicon single crystal produced by this CZ method, there may be formed defects called COPs, dislocation clusters and so on. These defects are not ones newly formed in the step of heat treatment following the pulling up by the CZ method but are defects formed in the single crystal in the process of growing the single crystal. They are called grown-in defects.

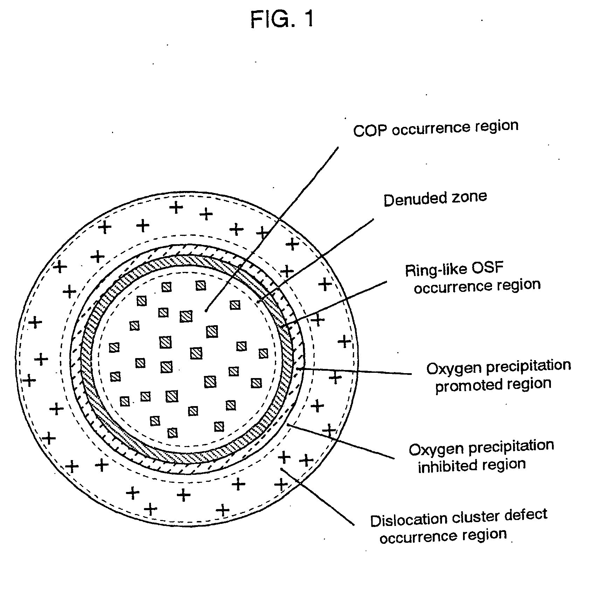

Fig. 1 is a schematic drawing which shows the distribution of grown-in defects formed in the cross section of a crystal during the single crystal growing process. This observation of the distribution of grown-in defects was carried out by slicing a wafer from a single crystal just after growing, immersing the wafer in an aqueous solution of copper nitrate for deposition of Cu and, after heat treatment, performing X-ray topography.

On the wafer shown in Fig. 1, there are formed oxidation-induced stacking faults (hereinafter referred to as "OSFs"), a kind of heat treatment-induced defect, forming a ring-like pattern of OSFs (hereinafter referred to as "R-OSF"). The inside of R-OSF occurring on the wafer face is a region of occurrence of COPs among the grown-in defects observable upon evaluation after single crystal growth. There is a defect-free zone adjacent to the inside the R-OSF region. In this defect-free zone, any COPs of not less than 0.1 µm in size will not be detected.

On the other hand, in the area adjacent to the outside of the R-OSF region, there exists an oxygen precipitation enhanced region where oxygen precipitation may easily occur and, outside of this region, there exists an oxygen precipitation inhibited region where oxygen precipitation hardly occurs. In either of the oxygen precipitation enhanced region and the oxygen precipitation inhibited region, there exist no grown-in defects. However, outside of them is a region where grown-in defects called dislocation clusters occur.

The distribution of grown-in defects as mentioned above is greatly influenced by the pulling rate, in the process of single crystal growth by the CZ method. Namely, when the pulling rate is high, the region in which R-OSF potentially occur (hereinafter referred to as "Potential R-OSF region") is in the peripheral portion of the cross section of the single crystal and, as the pulling rate decreases, the Potential R-OSF region reduces its diameter from the outer to the inner portion and finally disappears at the center of the cross section of the single crystal.

The OSFs are interstitial-type dislocation loops generated upon oxidation heat treatment. Therefore, once OSFs have been formed and grown on the wafer surface, which is to be served as an active region for electric devices, they cause leakage currents and serve as a factor deteriorating device characteristics. For avoiding this, in the prior art, the pulling rate during the single crystal growth has been increased as far as possible, for example set at not less than 0.8 mm/min, so that the Potential R-OSF region may be shifted to the peripheral portion of the cross section of the single crystal. The Potential R-OSF region where OSFs occur in a high density is thereby pushed away to the periphery of the wafer.

Recently, however, the temperature in the device production process has been lowered and the time of high temperature heat treatment shortened, whereby the adverse influences of OSFs on devices have been reduced. Thus, the problem of OSFs as a factor deteriorating device characteristics is now of little significance.

On the contrary, among grown-in defects, COPs are a factor deteriorating the time-zero dielectric breakdown characteristics, and dislocation clusters are also a factor capable of markedly deteriorating device characteristics. Therefore, it has recently become important to learn how to suppress these grown-in defects from being formed in the crystal, or how to reduce the density thereof if they are formed.

When the above problem is considered in connection with the productivity, a single crystal obtained by increasing the pulling rate is superior in productivity and, at the same time, can be a dislocation cluster-free one since, as discussed above, the Potential R-OSF region can be shifted to the periphery of the cross section of the crystal by increasing the pulling rate in the process of single crystal growth. However, in such a single crystal, large-sized COPs are formed in a high density inside the Potential R-OSF region and deteriorate the gate oxide integrity characteristics of MOS devices.

Therefore, in Japanese Patent Application Laid-open No. 2000-327486, there is proposed a method of growing silicon single crystals free of COPs and dislocation clusters, which deteriorate device characteristics, which method comprises controlling the ratio V/G and the radial distribution of the ratio V/G, where G is the temperature gradient in the axial direction within the crystal and V is the pulling rate, within respective specific ranges.

According to this proposal, high-quality silicon single crystals free of COPs or dislocation clusters can indeed be obtained but it is necessary that the axial direction temperature gradient G should be sufficiently steep in order to increase the pulling speed. Therefore, the hot zone structure within the CZ furnace is adjusted to increase the axial direction temperature gradient G within the crystal. The adjustment of the hot zone structure has its limits because of the furnace structure and, as a result, the single crystal pulling rate has to be fairly reduced and this causes a problem that the efficiency of silicon single crystal production becomes worse.

In Japanese Patent Application Laid-open No. Hei11(1999)-79889, it is disclosed that when a relatively high pulling rate is employed by employing the CZ method under application of a magnetic field, a defect-free zone free of COPs or dislocation clusters can be also formed and, at the same time, the allowance of the pulling rate within which this defect-free zone can be formed can be enlarged. However, even in the method disclosed in the above-cited publication, the pulling rate is not yet sufficient for efficient production in actually pulling up single crystals; in addition, the allowable pulling rate range within which defect-free zone formation is possible is narrow and unsatisfactory.

### Disclosure of the Invention

In recent years, methods have been proposed of pulling up silicon single crystals having a uniform impurity concentration all over a crystal which comprise rotating only the silicon melt in the crucible without forcedly rotating the crucible (e.g. Japanese Patent No. 2,959,543). More specifically, in silicon single crystal growth, a magnetic field is applied to the silicon melt and an electric current perpendicular to the magnetic field is further applied to the silicon melt, whereby the melt is caused to rotate by the Lorentz force. This silicon single crystal production method is called the Electromagnetic CZ method (hereinafter referred to as "EMCZ method").

According to this EMCZ method, it is possible to rotate the silicon melt by the Lorentz force without rotating the crucible and, further, it is possible to arbitrarily control the rotation rate of the melt by adjusting the electric current to be applied. Therefore, it becomes possible to readily control the concentration of impurity elements incorporated in the crystal.

The present inventors made intensive investigations concerning various methods of growing silicon single crystals in order to produce silicon single crystals with no grown-in defects, or with a very low density of grown-in defects if formed, with high productivity and under conditions such that the allowable pulling rate range is wide. As a result, it was found that to pull up a single crystal while applying a magnetic field to the silicon melt and, at the same time, applying an electric current containing a component perpendicular to this magnetic field to the silicon melt, namely to use the EMCZ method, is effective in suppressing the formation of grown-in defects and, at the same time, in improving the pulling rate. Based on this finding, the present invention has now been completed.

The gist of the present invention consists in a method of producing silicon single crystals which comprises using the EMCZ method, adjusting the pulling rate in the process of single crystal growth and thereby growing a single crystal under conditions such that the outside diameter of the Potential R-OSF region is within the range of 70% to 0% of the crystal diameter.

Wafers sliced from the crystal region in which the outside diameter of the Potential R-OSF region is within the range of 70% to 0% of the crystal diameter have a crystal quality characterized by excellent gate oxide integrity characteristics. When the outside diameter of the Potential R-OSF region exceeds 70%, relatively large-sized COPs occur in a high density in the central portion of the crystal. Therefore, it is necessary to adjust the pulling rate so that the above-mentioned outside diameter may not exceed 70%.

It is a characteristic feature of the method of the present invention that silicon single crystals in which the outside diameter of the Potential R-OSF region is within the range of 70% to 0% can be produced with high productivity. The reason therefor is not clear. In the ordinary CZ method and the CZ method under application of a magnetic field, the crucible is rotated, so that the convection of the melt in the crucible becomes more intense at the site closer to the crucible wall and small just below the single crystal growth interface. On the contrary, in the EMCZ method, the Lorentz force directly rotates the silicon melt, so that the convection of the melt is estimated to be able to become relatively intense even just below the growing crystal. Accordingly, the temperature gradient in the melt just below the crystal possibly becomes less in the EMCZ method than that in the ordinary CZ method or in the CZ method under application of a magnetic field, presumably with the result that the pulling rate can be increased and the allowable range thereof is enlarged.

In the silicon single crystal producing method according to the invention, it is preferable that the portion of the single crystal in which, the outside diameter of the Potential R-OSF region amounts to 70% to 0% of the crystal diameter account for not less than one third (1/3) of the length of the cylindrical body portion of the single crystal.

In the silicon single crystal producing method according to the invention, it is preferable that the portion of the single crystal in which the outside diameter of the Potential R-OSF region amounts to 70% to 0% of the crystal diameter consist of a region substantially free of COPs with not less than 0.1 µm in size, and of dislocation clusters.

Among COPs generated inside the Potential R-OSF region, those COPs which are not less than 0.1 µm in diameter are thermally very stable, so that supposedly they will not distinguish even when they are subjected to high temperature heat treatment in the device producing process but will remain in the active region in the vicinity of the wafer surface and thus deteriorate the junction leak characteristics. The dislocation clusters serve as a factor deteriorating device characteristics. For growing silicon single crystals further improved in quality, it is effective to adjust the growing conditions so that the crystals may consist of a region substantially free of COPs with not less than 0.1 µm in size, and of dislocation clusters.

In the silicon single crystal producing method according to the invention, it is preferable that the pulling rate be adjusted within the range of 0.6 to 1.6 mm/min. When the pulling rate is slower than 0.6 mm/min, dislocation clusters occur in the peripheral portion of the crystal and deteriorate device characteristics. When the pulling rate exceeds 1.6 mm/min, the Potential R-OSF region cannot be adjusted any longer to the range of 70% of the crystal diameter but, rather, COPs greater in size are formed in a high density from the central portion of the crystal, deteriorating the gate oxide integrity and junction leak characteristics.

From the viewpoint of further improvement in the quality of the single crystal, it is possible to grow silicon single crystals consisting of a region substantially free of COPs with not less than 0.1 µm in size, and of dislocation clusters by adjusting the mean pulling rate to a level not higher than 1.2 mm/min.

In the silicon single crystal producing method according to the invention, it is preferable that the growth be effected under conditions satisfying the relation Gc/Ge ≧ 1.0, where Gc is the temperature gradient in the direction of the pulling axis in the central portion of the single crystal and Ge is the temperature gradient in the peripheral portion of the single crystal, within the temperature range of from the melting point to 1,300°C.

Employment of such constitution is particularly effective in uniformly enlarging, in the direction of crystal diameter, the region substantially free of COPs with a size of not less than 0.1 µm and of dislocation clusters. However, when the ratio Gc/Ge is less than 1.0, it is not possible to obtain crystals that are uniform in quality in the direction of crystal diameter.

In the silicon single crystal producing method according to the invention, it is preferable that the magnetic field applied to the silicon melt contain a longitudinal magnetic field component. In particular, from the viewpoint of oxygen concentration distribution and of the uniformity in resistivity distribution in the wafer, it is preferable to apply a cusp magnetic field.

In the silicon single crystal producing method according to the invention, it is preferable that the cusp magnetic field to be applied to the silicon melt have an intensity of not less than 0.03 T. When it is less than 0.03 T, the silicon melt stirring effect produced by the Lorentz force is slight, so that the pulling rate cannot be increased. The magnetic field intensity is preferably as high as possible from the crystal quality viewpoint but is restricted by the apparatus structure and its capacity viewpoint.

In the silicon single crystal producing method according to the invention, it is preferable that the electric current be passed through the silicon melt within the range of 1 to 20 A. When the electric current is less than 1 A, the rotation of the silicon melt by the Lorentz force becomes slow and the convection of the melt just below the single crystal becomes reduced, so that the pulling rate cannot be increased. On the other hand, when the electric current exceeds 20 A, the electric resistance of the neck portion, whose diameter is generally about 3 mm, causes Joule heat generation in this neck portion; and the strength of the neck portion is thus reduced.

In the silicon single crystal producing method according to the invention, it is preferable that the crucible not be rotated in the process of producing the cylindrical body portion of the silicon single crystal. When the crucible is rotated, the convection of the melt just below the single crystal growth interface decreases in intensity, hence the pulling rate cannot be improved.

### Brief Description of the Drawings

Fig. 1 is a schematic drawing which shows a typical distribution of grown-in defects formed in the cross section of a crystal in the process of single crystal growth.
Fig. 2 is a schematic drawing, in section of the constitution of a single crystal pulling apparatus to be used in the silicon single crystal production according to the present invention.
Fig. 3 is a graph based on the evaluation results described in the examples, of the pulling rate at which a region (N region) free of COPs with not less than 0.1 µm in size, and of dislocation clusters is formed in the crystal.

### Best Modes for Carrying out the Invention

A preferred embodiment of the present invention is described based on the following example.

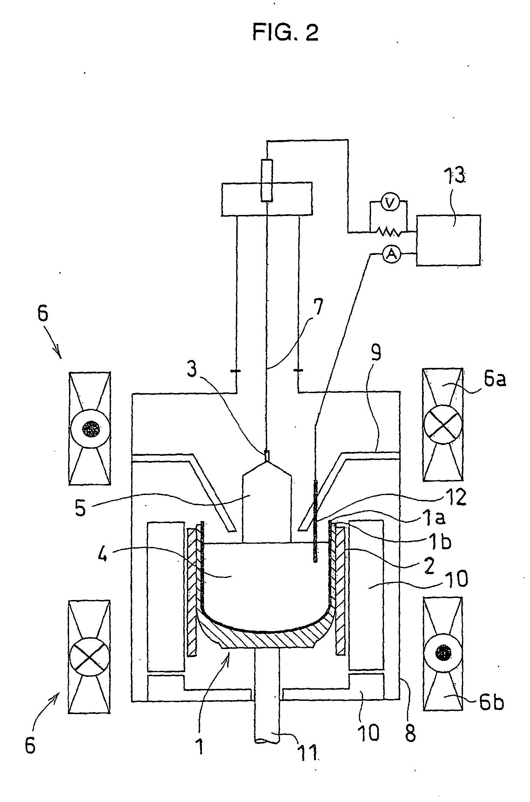

Fig. 2 is a schematic drawing, in section, of the constitution of a single crystal pulling apparatus to be used in the silicon single crystal production according to the present invention. In the apparatus for pulling up single crystals as shown in Fig. 2, a seed crystal 3 is brought into contact with the melt 4 charged in a crucible 1 constituted of a quartz crucible 1a and a graphite crucible 1b, and a single crystal 5 is grown while the seed crystal 3 is pulled up. Furthermore, after contacting the seed crystal 3 with the surface of the melt 2 by means of a pulling shaft 7, a single crystal 5 is pulled up while the seed crystal 3 is rotated. A heat shield 9 is provided so as to surround the single crystal being pulled up.

The crucible 1 is supported by a crucible lifting shaft 11 and, around the crucible 1, there are disposed a heater 2 for heating the melt, and a heat insulator 10. Around the furnace body 8 of the apparatus for pulling up single crystals, there are disposed a pair of upper and lower opposing coils 6 for magnetic field application, with the crucible at the center. The structure is thus such that a cusp magnetic field is formed in the melt 4 in the crucible by applying electric currents opposite in direction to each other to the pair of the upper coil 6a and lower coil 6b.

Further, an electrode 12 is immersed in the silicon melt 4 in the crucible 1, and an electric current is applied to the electrode 12 immersed in the melt 4 and to the pulling shaft 7 from a power source 13 disposed outside the furnace body 8 so that a current may pass through between the silicon melt 4 and single crystal 5. As a result, the current passes in the direction perpendicular to the magnetic field and the Lorentz force rotates the silicon melt 4.

In the method of the invention, those hot zone conditions are determined in advance by overall heat transfer calculations under which conditions, the temperature gradient relation Gc/Ge ≧ 1.0 is satisfied in the temperature range from the melting point to 1,300°C, where Gc is the mean temperature gradient in the direction of pulling axis in the central portion of the single crystal in that temperature range and Ge is the mean temperature gradient in the peripheral portion of the single crystal. And, the apparatus for pulling up single crystals which is to be used in the producing method of the invention is adjusted with respect to the relative positions of the crucible 1 and heater 2, the thickness of the heat shield 9, the distance between the tip of the heat shield 9 and the surface of the silicon melt 4, the structure of the heat insulator 10 and so forth so that the conditions preliminarily determined may be satisfied.

Using the above-mentioned apparatus for pulling up single crystals, experiments were carried out under the conditions mentioned below while varying the pulling rate to find out the pulling rate range necessary for obtaining silicon single crystals comprising a region free of COPs with not less than 0.1 µm in size, and of dislocation clusters.

Here, the silicon single crystal to be produced was required to meet the following conditions: oxygen concentration 24 ppma, diameter 200 mm, cylindrical body length 1,200 mm, and crystal orientation <001>. First, the quartz crucible of 26 inch diameter was charged with 120 kg of a polycrystalline silicon material, the p-type dopant boron was added to give an electric resistivity in the single crystal of 10 Ωcm, the polycrystalline silicon material in the quartz crucible 1a was melted by heating with the cylindrical graphite heater 2 disposed around the graphite crucible 1b.

Then, the positions of the coils 6 were adjusted so that the cusp magnetic field center giving a cusp magnetic field intensity of 0 (zero) might be located at the center within the melt and 80 mm below the melt surface, and a cusp magnetic field was applied so that the horizontal magnetic field intensity perpendicular to the side wall of the crucible 1 at a height of 80 mm below the melt surface might amount to 0.09 T and the vertical magnetic field intensity at the center of the bottom wall of the crucible 1 at the initial stage of pulling might amount to 0.07 T.

Thereafter, the lower end of a seed crystal 3 was immersed in the melt 4, and a silicon single crystal 5 was grown at the lower end of the seed crystal 3 by pulling up the pulling shaft upwards while the crucible lifting shaft 11 and pulling shaft 7 were rotated in directions opposite to each other. Here, the crucible 1 was lifted upwards with the growth of the single crystal, so that the position of the surface of the melt 4 was always maintained constant relative to the heater 2 and cusp magnetic field application coils 6.

Then, after seed constricting for rendering the single crystal to be grown dislocation-free, a shoulder was formed, and the shoulder diameter was caused to increase to the desired body diameter. At the time when the single crystal diameter reached the desired body diameter, an electric current of 8 A was passed through the silicon melt 4 and the silicon single crystal 5 to thereby generate Lorentz force generation in the circumferential direction for rotating the melt in the quartz crucible 1a. The rotational speed of the crystal on that occasion was 6 rpm and that of the crucible was 0 rpm.

At the time when the body length reached 300 mm, the pulling rate was adjusted to 1.0 mm/min and, thereafter, the pulling rate was lowered almost linearly according to the pulling up length, so that it amounted to 0.3 mm/min when the body length reached 600 mm. Thereafter, the same pulling rate was maintained and the growth was completed.

In Comparative Example 1, a silicon single crystal was grown by the ordinary CZ method under the same conditions as in the above-mentioned process except that no cusp magnetic field was applied to the silicon melt and no electric current was passed through the same. Similarly, in Comparative Example 2, a silicon single crystal was grown while applying a transverse magnetic field of 0.3 T to the silicon melt. In each comparative example, the rotational speed of the crucible in forming the single crystal body portion was 5 rpm.

Wafers were sliced from each of the silicon single crystals obtained in the example of the present invention and Comparative Examples 1 and 2. For each wafer, COPs with not less than 0.1 µm in size, were counted using a surface inspector (KLA-Tencor model SP-1). The surface of each wafer was etched by immersing the wafer in the Secco solution (K₂Cr₂O₇ + HF + H₂O) and then the wafer surface was examined by an optical microscope for the occurrence or absence of dislocation clusters.

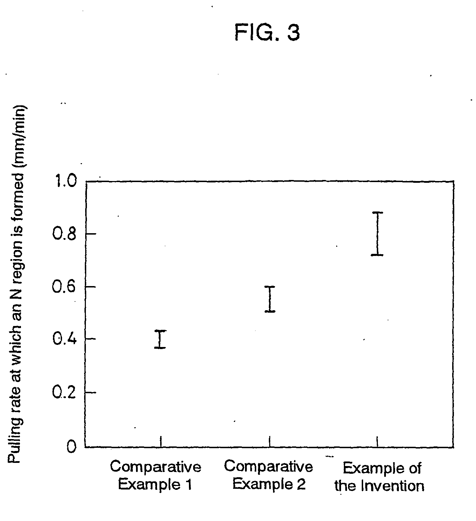

Fig. 3 is a graph, based on the results of the above evaluations described above, of the pulling rate at which a region (N region) free of COPs with not less than 0.1 µm in size, and of dislocation clusters is formed in the crystal. As is evident from the figure, even in Comparative Example 2 in which a transverse magnetic field was applied to the silicon melt, hence the pulling rate is regarded as fast, the range of the rate was about 0.55 ± 0.05 mm/min, whereas, in the example of the invention, the pulling rate was in the range of 0.8 ± 0.08 mm/min, indicating the increase in pulling rate as well as the widened allowable pulling rate range.

From the above evaluation results, it was further found that the pulling rate at which silicon wafers consisting of an oxygen precipitation enhanced region alone can be obtained under the conditions of the example of the invention is 0.75 ± 0.03 mm/min. Therefore, in the actual single crystal body portion forming process, a silicon single crystal was pulled up at a pulling rate of 0.75 ± 0.03 mm/min under the above-mentioned conditions of the example of the invention, and the distribution of defects throughout the body portion of the single crystal was examined.

Based on the results of the examination, it was confirmed that a silicon single crystal whose cylindrical body section, except for the portion of 100mm from the top, wholly consisted of an oxygen precipitation enhanced region alone could have been produced.

### Industrial Applicability

According to the silicon single crystal producing method of the invention, silicon single crystals excellent in device characteristics such as gate oxide integrity or the like can be produced without the formation of COPs with not less than 0.1 µm in size, or of dislocation clusters in the cross section of the crystal by adjusting the pulling rate in the single crystal growing process so that the outside diameter of the Potential R-OSF region in the cross section of the crystal may be within the range of 70% to 0% of the crystal diameter. In addition, these silicon single crystals can be produced with high productivity and under growing conditions such that a wide range of pulling rate can be allowed. Therefore, they can be used widely for semiconductor devices.

## Claims

1. A method of producing silicon single crystals by the Czochralski method while applying a magnetic field to the silicon melt and applying an electric current perpendicular to the magnetic field to the silicon melt, which method comprises:
pulling a single crystal from the silicon melt at an adjusted pulling rate within the range of 0.6 to 1.6 mm/min; and
carrying out the growing of the single crystal In the temperature range from the melting point to 1300°C under conditions such that the relation Gc/Ge ≧ 1.0 is satisfied, where Gc is the temperature gradient in the direction of pulling axis in the central portion of the single crystal and Ge is the temperature gradient in the peripheral portion of the single crystal, during a single crystal growing process so that an outside diameter of a potential region of oxidation-induced stacking faults occurring in the cross section of the single crystal is within the range of 70% to 0% of the crystal diameter.

2. A method of producing silicon single crystals as claimed in claim 1, wherein, in the silicon single crystal cross section perpendicular to the pulling axis, that portion of the single crystal in which the outside diameter of the potential region of oxidation-induced stacking faults amounts to 70% to 0% of the crystal diameter amounts to not less than one third of the length of the cylindrical body portion of the single crystal.

3. A method of producing silicon single crystals as claimed in claim 1 or 2, wherein that portion of the single crystal in which the outside diameter of the potential region of oxidation-induced stacking faults appearing in the crystal plane amounts to 70% to 0% of the crystal diameter is free of COPs with not less than 0.1 mu m in size, and of dislocation clusters.

4. A method of producing silicon single crystals as claimed in any of claims 1 to 3, wherein the magnetic field applied to the silicon melt contains a longitudinal magnetic field component.

5. A method of producing silicon single crystals as claimed in claim 4, wherein the magnetic field applied to the silicon melt is a cusp magnetic field.

6. A method of producing silicon single crystals as claimed in claim 5, wherein the cusp magnetic field applied to the silicon melt has an intensity of not less than 0.03 T.

7. A method of producing silicon single crystals as claimed in any of claims 1 to 6. wherein the electric current applied to the silicon melt is within the range of 1 to 20 A.

8. A method of producing silicon single crystals as claimed in any of claims 1 to 7, wherein the crucible is not rotated in the process of producing the cylindrical body portion of the silicon single crystal.

## Patentansprüche

1. Verfahren zur Herstellung von Silizium-Einkristallen durch das Czochralski-Verfahren bei Anlegung eines Magnetfelds an die Silizium-Schmelze und bei Anlegung von einem elektrischen Strom senkrecht zu dem Magnetfeld an die Silizium-Schmelze, wobei das Verfahren umfasst:
Ziehen eines Einkristalls aus der Silizium-Schmelze bei einer eingestellten Zieh-Geschwindigkeit innerhalb des Bereichs von 0,6 bis 1,6 mm/min; und
Durchführen der Züchtung des Einkristalls in dem Temperaturbereich von dem Schmelzpunkt bis 1300°C unter solchen Bedingungen, dass das Verhältnis Gc/Ge ≥ 1,0 erfüllt ist, wobei Gc der Temperaturgradient in der Richtung der Zugachse im mittleren Abschnitt des Einkristalls ist und Ge der Temperaturgradient in dem Randabschnitt des Einkristalls ist, während eines Einkristallzuchtverfahrens, so dass ein Außendurchmesser eines möglichen Gebiets von oxidationsinduzierten Stapelfehlern, die in dem Querschnitt des Einkristall auftreten, innerhalb des Bereichs von 70% bis 0% des Kristalldurchmessers liegt.

2. Verfahren zur Herstellung von Silizium-Einkristallen nach Anspruch 1, wobei in dem Silizium-Einkristall-Querschnitt senkrecht zu der Zugachse derjenige Abschnitt des Einkristalls, in welchem der Außendurchmesser des möglichen Gebiets von oxidationsinduzierten Stapelfehlern von 70% bis 0% des Kristalldurchmessers ausmacht, nicht weniger als ein Drittel der Länge des zylindrischen Körperabschnitts des Einkristalls ausmacht.

3. Verfahren zur Herstellung von Silizium-Einkristallen nach Anspruch 1 oder 2, wobei derjenige Abschnitt des Einkristalls, in welchem der Aussendurchmesser des möglichen Gebiets von oxidationsinduzierten Stapelfehlern, die in der Kristallebene auftreten, 70% bis 0% des Kristalldurchmessers ausmacht, frei von COPs mit nicht weniger als 0,1 µm Größe und von Fehlordnungsclustern ist.

4. Verfahren zur Herstellung von Silizium-Einkristallen nach einem der Ansprüche 1 bis 3, wobei das an die Silizium-Schmelze angelegte Magnetfeld eine Magnetfeldkomponente in Längsrichtung enthält.

5. Verfahren zur Herstellung von Silizium-Einkristallen nach Anspruch 4, wobei das an die Silizium-Schmelze angelegte Magnetfeld ein Cusp-Magnetfeld ist.

6. Verfahren zur Herstellung von Silizium-Einkristallen nach Anspruch 5, wobei das an die Silizium-Schmelze angelegte Cusp-Magnetfeld eine Intensität von nicht weniger als 0,03 T aufweist.

7. Verfahren zur Herstellung von Silizium-Einkristallen nach einem der Ansprüche 1 bis 6, wobei der an die Silizium-Schmelze angelegte Strom im Bereich von 1 bis 20 A liegt.

8. Verfahren zur Herstellung von Silizium-Einkristallen nach einem der Ansprüche 1 bis 7, wobei der Tiegel in dem Verfahren zur Herstellung des zylindrischen Körperabschnitts des Silizium-Einkristalls nicht rotiert wird.

## Revendications

1. Procédé de production de monocristaux de silicium par le procédé de Czochralski tout en appliquant un champ magnétique au produit de fusion de silicium et en appliquant un courant électrique perpendiculaire au champ magnétique au produit de fusion de silicium, lequel procédé comprend :
le tirage d'un monocristal à partir du produit de fusion de silicium à un taux de tirage ajusté dans la gamme de 0,6 à 1,6 mm/min ; et
la réalisation de la croissance du monocristal dans la gamme de températures allant du point de fusion à 1 300 °C dans des conditions telles que la relation Gc/Ge ≧ 1,0 est satisfaite, où Gc est le gradient de température dans la direction de l'axe de tirage dans la portion centrale de monocristal et Ge est le gradient de température dans la portion périphérique du monocristal, pendant qu'un procédé de croissance de monocristal de sorte qu'un diamètre externe d'une région potentielle de défauts d'empilement induits par l'oxydation se produisant dans la section du monocristal est dans la gamme de 70 % à 0 % du diamètre du cristal.

2. Procédé de production de monocristaux de silicium selon la revendication 1, dans lequel, dans la section de monocristal de silicium perpendiculaire à l'axe de tirage, cette portion du monocristal dans laquelle le diamètre externe de la région potentielle de défauts d'empilement induits par l'oxydation s'élève à 70 % à 0 % du diamètre du cristal, s'élève à pas moins d'un tiers de la longueur de la portion de corps cylindrique du monocristal.

3. Procédé de production de monocristaux de silicium selon la revendication 1 ou 2, dans lequel cette portion du monocristal dans laquelle le diamètre externe de la région potentielle de défauts d'empilement induits par l'oxydation apparaissant dans le plan de cristal s'élève à 70 % à 0 % du diamètre du cristal, est dépourvue de COP (particules d'origine cristalline) d'une taille non inférieure à 0,1 µm et de grappes de dislocation.

4. Procédé de production de monocristaux de silicium selon l'une quelconque des revendications 1 à 3, dans lequel le champ magnétique appliqué au produit de fusion de silicium contient une composante de champ magnétique longitudinale.

5. Procédé de production de monocristaux de silicium selon la revendication 4, dans lequel le champ magnétique appliqué au produit de fusion de silicium est un champ magnétique cuspidé.

6. Procédé de production de monocristaux de silicium selon la revendication 5, dans lequel le champ magnétique cuspidé appliqué au produit de fusion de silicium a une intensité non inférieure à 0,03 T.

7. Procédé de production de monocristaux de silicium selon l'une quelconque des revendications 1 à 6, dans lequel le courant électrique appliqué au produit de fusion de silicium est dans la gamme de 1 à 20 A.

8. Procédé de production de monocristaux de silicium selon l'une quelconque des revendications 1 à 7, dans lequel le creuset n'est pas mis en rotation dans le procédé de production de la portion de corps cylindrique du monocristal de silicium.
